Europäisches Patentamt

European Patent Office

Office européen des brevets

(19)

(11) Veröffentlichungsnummer: **0 191 341 B1**

(12) **EUROPÄISCHE PATENTSCHRIFT**

(45) Veröffentlichungstag der Patentschrift: **12.06.91**

(51) Int. Cl.⁵: **H03H 11/12**

(21) Anmeldenummer: **86101007.2**

(22) Anmeldetag: **25.01.86**

(54) **Aktives Sperrfilter.**

(30) Priorität: **15.02.85 DE 3505209**

(43) Veröffentlichungstag der Anmeldung:
**20.08.86 Patentblatt 86/34**

(45) Bekanntmachung des Hinweises auf die
Patenterteilung:
**12.06.91 Patentblatt 91/24**

(84) Benannte Vertragsstaaten:
**AT CH DE FR GB LI NL**

(56) Entgegenhaltungen:
**FR-A- 1 466 808**
**FR-A- 2 543 761**

**ARCHIV FÜR TECHNISCHES MESSEN UND IN-
DUSTRIELLE MESSTECHNIK, Nr. 424, Mai
1971, Seiten 93-96, München, DE; H.L. KÖNIG:
"Aktive RC-Filter, Teil II"**

**FUNKSCHAU, Band 39, Nr. 24, 2. Dezember
1967, Seite 762, München, DE; H.N. KARP:
"Aktive RC-Filter zur Klangerzeugung bei
elektronischen Orgeln"**

**Radio Communications Handbook/Radio Society of Great Britain 1982, Potters Bar,
Herts. p. 9.27**

(73) Patentinhaber: **Deutsche Thomson-Brandt
GmbH
Hermann-Schwer-Strasse 3 Postfach 1307
W-7730 Villingen-Schwenningen(DE)**

(72) Erfinder: **Porges, Ivan
Schertlestrasse 9
W-7730 Villingen-Schwenningen(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein aktives Bandsperrfilter nach dem Oberbegriff des Anspruchs 1.

Es sind aktive Filterschaltungen bekannt, bei denen im Rückkopplungszweig eines Verstärkers RC-Kombinationen zur Erzielung bestimmter Frequenzgänge angeordnet sind. Beschrieben sind diese Schaltungen z.B. in dem Fachbuch von U. Tietze und Ch. Schenk "Halbleiterschaltungstechnik", erschienen im Springer-Verlag Berlin, Heidelberg, New York, Tokio 1983 auf den Seiten 376 bis 439. Diese Schaltungen haben gegenüber konventionellen Filterschaltungen mit Spulen, Kondensatoren und Widerständen den Vorteil, daß sie mit relativ geringem Schaltungsaufwand in Verbindung mit Operationsverstärkern auskommen.

Auch sind Transistorschaltungen bekannt, beschrieben ebenfalls im Fachbuch U. Tietze, Ch. Schenk in der Ausgabe von 1971 auf Seite 106, mit denen bei einem in Kollektorschaltung betriebenen Transistor die Spannungsteilerwiderstände für die Erzeugung der Basisvorspannung über einen Längswiderstand zur Basis geführt sind. Zwischen dem gemeinsamen Verbindungspunkt dieser drei Widerstände und dem Emitteranschluß des Transistors ist ein Kondensator geschaltet. Dieser Kondensator ist so gewählt, daß sein Wechselstromwiderstand für die angelegte Frequenz der Eingangswechselspannung einen sehr geringen Wert aufweist. Durch diese Schaltung, auch Bootstrap-Schaltung genannt, wird erreicht, daß der wechselspannungsmäßig parallel zum Emitterwiderstand liegende Spannungsteilerwiderstand dynamisch vergrößert wird, so daß mit dieser Schaltung hohe Eingangswiderstände bei geringem Ausgangswiderstand realisiert werden können.

Aus dem Schaltbild des HiFi-Empfängers TRX 3000 der Firma Telefunken ist ferner ein aktives 9 kHz-Sperrfilter mit einem Transistor, der in Kollektorschaltung betrieben ist, bekannt. Ein auf die Sperrfrequenz abgestimmtes Netzwerk, bestehend aus RC- und CR-Kombinationen ist zwischen Schaltungspunkten an der Basis und dem Mittelpunkt zweier in Reihe liegender Emitterwiderstände des Transistors geschaltet.

Es ist Aufgabe der Erfindung, eine Schaltungsanordnung für einen Transistor mit geringem Aufwand aufzuzeigen, mit der einerseits eine bestimmte selektive Filterwirkung erreicht wird und die andererseits die Vorteile einer Kollektorschaltung, nämlich hohen Eingangswiderstand bei geringem Ausgangswiderstand aufweist.

Diese Aufgabe wird durch die im Anspruch 1 beschriebene schaltung erfüllt. Vorteilhafte Weiterbildungen der Schaltung sind in den Unteransprüchen beschrieben.

Im Prinzip besteht die Erfindung darin, daß eine Reihenschaltung von Spule L und Kondensator C, auch Leit- oder Saugkreis genannt, zwischen Emitter und Basis angeordnet ist. Allerdings ist dieser Leitkreis nicht direkt am Emitteranschluß sondern am Verbindungspunkt zweier in Reihe geschalteter Emitterwiderstände angeschlossen. Der zwischen Emitteranschluß und Leitkreis liegende Widerstand dient zur Einstellung eines möglichst geringen Überschwingens im Durchlaßbereich bzw. der Flankensteilheit, d.h. dem Grad der Entdämpfung dieses im Rückkopplungszweig liegenden Leitkreises. Daher ist es ein großer Vorteil dieser aktiven Schaltung, daß das wählbare Verhältnis von L zu C für eine vorbestimmte Frequenz, d.h. der Resonanzwiderstand des Leitkreises relativ unkritisch für den Verlauf der Resonanzkurve ist.

Bei einer bevorzugten Anwendung der Erfindung wird diese Schaltung in Rundfunk-HiFi-Geräten zwischen dem Ausgang eines Stereoton-Decoders und einem diesem folgenden Niederfrequenzverstärker eingesetzt. Nach der neuen DIN-IEC-Norm 29B (CO) 94 müssen nämlich diejenigen Störsignale unterdrückt werden, die bei der Messung der Hilfsträgerunterdrückung einschließlich Seitenbändern auftreten können. Dies sind die Frequenzen 38 kHz, 38-1 kHz und 38 + 1 kHz.

Diese Forderungen werden durch die beschriebene Schaltungsanordnung besonders gut erfüllt, da eingangsseitig die Schaltung so hochohmig ist, daß der gleichzeitig die Deemphasis enthaltende Arbeitswiderstand des Demodulators, der als Generator dient, so ausgelegt werden kann, daß die Spannungsverstärkung des Stereodecoders in weiten Grenzen wunschgemäß eingestellt ist. Auch ist es möglich, durch die Anordnung zusätzlicher Kondensatoren, wie z.B. vor der Basis des Transistors die niederfrequente Flanke des Leitkreises zu versteilern und so bei geringer Welligkeit eine möglichst große Übertragungsbandbreite zu erreichen.

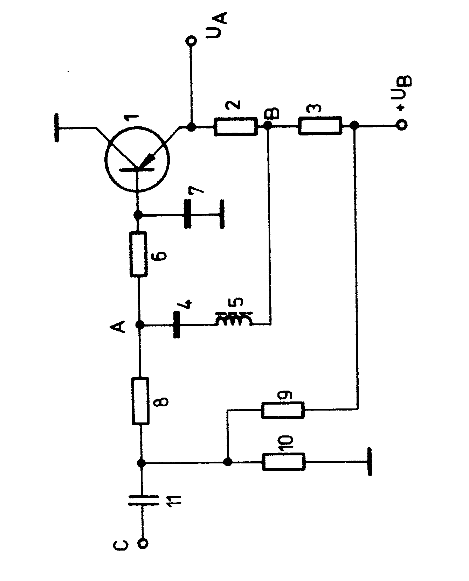

Die Erfindung wird im folgenden an Hand eines Auführungsbeispiels näher erläutert:
Die Figur zeigt eine aktive Filterschaltung, wie sie zwischen Stereodemodulator und den NF-Stufen eines HiFi-Rundfunkgerätes eingesetzt werden kann.

Am Eingang C liegt der nicht gezeichnete Wechselspannungsgenerator, der z.B. aus dem Arbeitswiderstand des Stereodecoders besteht. Dieser kann so ausgebildet sein, daß er als Deemphasisglied für den Decoder dient. Da der Eingang C der Schaltung hochohmig ist, kann der Generatorinnenwiderstand so ausgelegt werden, daß die Verstärkung des Stereodecoders wunschgemäß eingestellt werden kann.

Die Einstellung des Arbeitspunktes für den in Kollektorschaltung betriebenen Transistor 1 geschieht durch den Spannungsteiler mit den Widerständen 9 und 10. Diese müssen hochohmig gegenüber der Quellimpedanz sein. Das an C eingespeiste Signal wird über die Widerstände 8 und 6 der Basis zugeführt. Der Widerstand 6 bildet außerdem in Verbindung mit Kondensator 7 ein RC-Glied, welches hohe Frequenzanteile nach Masse ableitet. Am Verbindungspunkt A der Widerstände 8 und 6 ist der Leitkreis, bestehend aus der Reihenschaltung von Kondensator 4 mit Spule 5 angeschaltet. Dieser Leitkreis ist emitterseitig mit dem Verbindungspunkt B der Reihenschaltung der Emitterwiderstände 2 und 3 verbunden. Seine Resonanzfrequenz ist auf 38 kHz abgestimmt. Mit dem Widerstand 2 in Verbindung mit dem Längswiderstand 8 wird die gewünschte Sperrwirkung eingestellt.

Da die gezeichnete Schaltung einen Transistor vom PNP-Typ enthält, ist der Emitterwiderstand 3 nach + UB geführt und der Kollektor mit Masse, die am negativen Potential der Spannungsquelle liegt, verbunden. Das am Emitter stehende selektiv bei 38 +/- 1 kHz unterdrückte Ausgangssignal kann am Punkt UA abgenommen werden. Dabei ist es möglich, zusätzlich an diesem Punkt Schaltelemente anzuschließen, die einer evtl. auftretenden Schwingneigung bei hohen Frequenzen außerhalb des Übertragungsbereiches entgegenwirken.

Bezugszeichenliste

| 1  | Transistor   |
|----|--------------|
| 2  | Widerstand   |
| 3  | Widerstand   |
| 4  | Kondensator  |
| 5  | Spule        |
| 6  | Widerstand   |
| 7  | Kondensator  |
| 8  | Widerstand   |
| 9  | Widerstand   |
| 10 | Widerstand   |
| 11 | Kondensator  |

**Ansprüche**

1. Aktives Bandsperrfilter mit einem Transistor (1), dessen Emitterwiderstand aus einer Reihenschaltung von einem am Emitter angeschlosssenen ersten Widerstand (2) und einem weiteren Widerstand (3) besteht, deren Verbindungspunkt (B) über ein frequenzabhängiges Netzwerk an einen Schaltungspunkt (A) angeschlossen ist, der einerseits über einen Widerstand (6) mit der Basis und andererseits über einen Widerstand (8) mit einer Eingangsklemme (C) verbunden ist, dadurch gekennzeichnet, daß zwischen dem Schaltungspunkt (A) und dem Verbindungspunkt (B) der in Reihe geschalteten Emitterwiderstände (2,3) eine Reihenschaltung von einer Spule (5) mit einem Kondensator (4) angeordnet ist.

2. Aktives Bandsperrfilter nach Anspruch 1, dadurch gekennzeichnet, daß der Transistor (1) in Kollektorschaltung betrieben ist.

3. Aktives Bandsperrfilter nach einem der Ansprüche 1 und 2, dadurch gekennzeichnet, daß der am Emitteranschluß des Transistors (1) angeschlossene erste Widertand (2) in seinem Widerstandswert klein gegenüber dem Widerstandswert des weiteren in Reihe geschalteten Widertandes (3) ist.

4. Aktives Bandsperrfilter nach Anspruch 1, dadurch gekennzeichnet, daß zwischen Basis und Kollektor von Transistor (1) ein Kondensator (7) angeschaltet ist.

5. Bandsperrfilter nach einem der Ansprüche 1 - 4, dadurch gekennzeichnet, daß die Reihenschaltung von Spule (5) und Kondensator (4) eine Resonanzfrequenz von 38 kHz aufweist, der am Emitter angeordnete erste Widerstand (2) etwa 90 Ohm, der zwischen dem Schaltungspunkt (A) und der Eingangsklemme (C) angeordnete Widerstand etwa 10 kOhm und der zwischen dem Schaltungspunkt (A) und der Basis angeordnete Widerstand etwa 8,2 kOhm aufweist.

6. Aktives Bandsperrfilter nach einem der Ansprüche 1 - 5, dadurch gekennzeichnet, daß der am Emitter angeordnete Widerstand (2) einstellbar ist.

**Claims**

1. Active band suppression filter with a transistor (1) of which the emitter resistance comprises a series circuit consisting of a resistance (2) and a further resistance (3), the connection point (B) of these two resistances being connected by way of a frequency-dependent network to a circuit point (A) which is connected on the one hand to the base by way of a resistance (6) and on the other hand to an input terminal (C) by way of a resistance (8), characterised in that a series connection consisting of a coil (5) and a capacitor (4) is arranged between the circuit point (A) and the connection point (B) of the emitter resistances (2,3).

2. Active band suppression filter according to Claim 1, characterised in that the transistor (1) is operated in collector circuit.

3. Active band suppression filter according to either one of Claims 1 and 2, characterised in that the first resistance (2) connected to the emitter connection of the transistor (1) has a resistance value that is small as compared with the resistance value of the other resistance connected in series.

4. Active band suppression filter according to Claim 1, characterised in that a capacitor (7) is interposed between the base and the collector of the transistor (1).

5. Band suppression filter according to any one of Claims 1 to 4, characterised in that the series circuit comprising coil (5) and capacitor (4) has a resonance frequency of 38 kHz, the first resistance (2) arranged on the emitter is about 90 ohms, the resistance arranged between the circuit point (A) and the input terminal is about 10 kOhms, and the resistance arranged between the circuit point (A) and the base is about 8.2 kOhm.

6. Active band suppression filter according to any one of Claims 1 to 5, characterised in that the resistance (2) arranged on the emitter is adjustable.

**Revendications**

1. Filtre-bande actif avec un transistor (1) dont la résistance d' émetteur se compose d'un montage en série d'une première résistance (2) raccordée à l'émetteur et d'une autre résistance (3) dont le point de jonction (B) est raccordé par un réseau sélectif à un point de montage (A) qui est relié, d'une part, à la zone de base par une résistance (6) et, d'autre part, à une borne d'entrée (C) par une résistance (8), caractérisé en ce qu'un montage en série d'une bobine (5) et d'un condensateur (4) est placé entre le point de montage (A) et le point de jonction (B) des résistances d'émetteur (2, 3) montées en série.

2. Filtre-bande actif selon la revendication 1, caractérisé en ce que le transistor (1) fonctionne en montage à collecteur commun.

3. Filtre-bande actif selon l'une des revendications 1 et 2, caractérisé en ce que la valeur de résistance de la première résistance (2) raccordée à la borne d'émetteur du transistor (1) est petite par rapport à la valeur de résistance de l'autre résistance (3) montée en série.

4. Filtre-bande actif selon la revendication 1, caractérisé en ce qu'un condensateur (7) est monté entre la zone de base et le collecteur du transistor (1).

5. Filtre-bande selon l'une des revendications 1 à 4, caractérisé en ce que le montage en série de la bobine (5) et du condensateur (4) présente une fréquence de résonance de 38 kHz, la première résistance (2) placée sur l'émetteur approximativement 90 Ohm, la résistance placée entre le point de montage (A) et la borne d'entrée (C) approximativement 10 kOhm et la résistance placée entre le point de montage (A) et la zone de base approximativement 8,2 kOhm.

6. Filtre-bande actif selon l'une des revendications 1 à 5, caractérisé en ce que la résistance (2) placée sur l'émetteur est réglable.